# FASCICULE DE BREVET EUROPEEN

(11) **EP 1 496 549 B1**
(45) Date de publication et mention de la délivrance du brevet: **08.10.2008**
(21) Numéro de dépôt: 04103289.7
(22) Date de dépôt: 09.07.2004
(51) Int. Cl.: H01L 29/872, H01L 29/861, H01L 21/329, H01L 27/08, H01L 27/07

(54) **Diode de redressement et de protection**
Gleichrichter- und Schutzdiode
Rectifier and protection diode

(30) Priorité: 11.07.2003 FR 0350325
(43) Date de publication de la demande: 12.01.2005
(73) Titulaire: ST MICROELECTRONICS S.A., 92120 Montrouge (FR)
(72) Inventeur: MORAND, Jean-Luc, 37100, TOURS (FR); COLLARD, Emmanuel, 37100, TOURS (FR); LHORTE, André, 37550, SAINT AVERTIN (FR)
(74) Mandataire: de Beaumont, Michel

(56) Documents cités:
- US-A1- 2002 070 380
- US-B1- 6 175 143
- MANOJ MEHROTRA ET AL: "LOW FORWARD DROP JBS RECTIFIERS FABRICATED USING SUBMICRON TECHNOLOGY" IEEE TRANSACTIONS ON ELECTRON DEVICES, IEEE INC. NEW YORK, US, vol. 41, no. 9, 1 septembre 1994 (1994-09-01), pages 1655-1660, XP000466807 ISSN: 0018-9383
- HEFNER A ET AL: "Silicon carbide merged PiN schottky diode switching characteristics and evaluation for power supply applications" CONFERENCE PROCEEDINGS ARTICLE, vol. 5, 8 octobre 2000 (2000-10-08), pages 2948-2954, XP010521706

## Description

La présente invention concerne le domaine des diodes verticales destinées au redressement et/ou à la protection utilisées, par exemple, dans des alimentations de dispositifs portables tels que des appareils photographiques, des caméras, des agendas électroniques, des téléphones sans fils et/ou mobiles ou encore des ordinateurs portables.

Dans de telles applications, on utilise notamment des diodes Schottky ou des diodes à jonction PN.

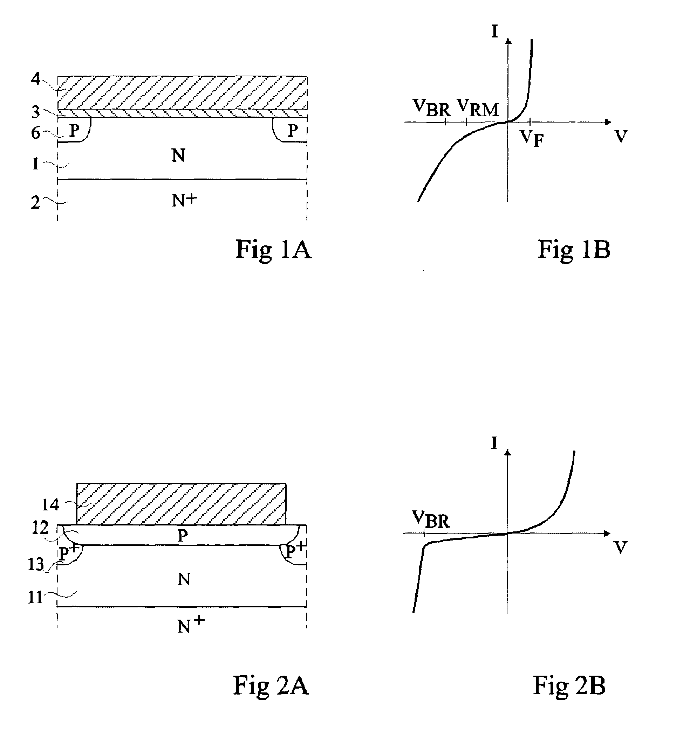

La figure 1A illustre, en vue en coupe partielle et schématique, une diode de puissance verticale de type Schottky. La diode Schottky est formée dans une couche semiconductrice 1 faiblement dopée d'un premier type de conductivité, généralement N. La couche 1 repose sur un substrat 2 plus fortement dopé de type N que la couche 1. Le substrat 2 est recouvert en face arrière d'une métallisation de cathode (non représentée). En face avant, la couche 1 est partiellement recouverte d'une couche mince 3 d'un matériau propre à former une jonction Schottky avec la couche 1. La couche 3 est solidaire d'une métallisation d'anode 4. La diode comporte généralement un anneau de garde 6 formé par diffusion en face avant à la surface de la couche 1. On notera que cet anneau de garde 6 peut être considéré comme formant une diode PN avec la couche 1, mais que cette diode PN n'est pas optimisée pour une fonction de protection.

La figure 1B illustre l'allure de la caractéristique I(V) d'une diode Schottky. Une diode Schottky présente une chute de tension en direct V_{F} faible, généralement inférieure à 0,5 V, même pour des courants importants, c'est-à-dire supérieurs à 1 A. Par contre, une diode Schottky présente un mauvais comportement en polarisation inverse, c'est-à-dire que l'avalanche est peu nette et que la courbe I(V) en inverse a une pente peu élevée, ce qui entraîne que la chute de tension aux bornes de la diode augmente fortement quand le courant inverse qui la traverse augmente.

La figure 2A est une vue en coupe schématique d'une diode PN verticale destinée à assurer une fonction de protection. La diode est formée dans un substrat semiconducteur 11 dopé de type N. En face arrière, la diode comprend une couche N fortement dopée (N⁺) revêtue d'une métallisation de cathode (non représentée). En face avant, le substrat 11 comporte une région 12 faiblement dopée de type P généralement entourée d'une région annulaire 13 très fortement dopée de type P. Une partie de la région 12 est solidaire d'une métallisation d'anode 14.

Comme l'illustre la figure 2B, une diode PN présente en polarisation inverse un comportement en avalanche satisfaisant à savoir qu'au delà d'une tension d'avalanche V_{BR} la pente de la courbe I(V) est très élevée. Toutefois, en polarisation directe, le composant 10 présente une chute de tension relativement élevée et qui varie avec le courant. Le dopage du substrat 11 est couramment de l'ordre de 10¹⁷ à 10¹⁸ at.cm⁻³ pour optimiser la caractéristique de claquage en inverse.

Ainsi, dans des applications où la fonction de redressement, c'est-à-dire l'obtention d'une faible chute de tension en direct, est essentielle, on utilise de préférence des diodes de type Schottky. Par contre, dans des applications où la fonction de protection, c'est-à-dire l'obtention d'une tension inverse sensiblement constante, est essentielle, on utilise de préférence des diodes de type PN.

Toutefois, dans de nombreuses applications parmi lesquelles des convertisseurs d'alimentation et/ou la protection d'alimentation ou de charges dans des dispositifs portables, il est souhaitable d'optimiser à la fois la fonction de redressement et la fonction de protection. La seule façon d'obtenir une chute de tension en direct faible, nettement inférieure à 0,6 V, étant d'utiliser une diode Schottky, on est amené à utiliser de telles diodes largement surdimensionnées pour éviter que la tension inverse ne croisse excessivement quand le courant inverse augmente, ce qui entraîne inévitablement que d'autres paramètres, et notamment le courant de fuite, sont dégradés. Il est impossible, tant avec les diodes Schottky qu'avec les composants à jonction PN, d'améliorer le comportement en inverse ou en direct sans affecter désavantageusement leur comportement en direct ou en inverse, respectivement. En effet, toute modification de dopage modifie les deux comportements.

La présente invention vise à proposer une diode verticale qui présente à la fois une faible chute de tension en direct et une caractéristique à pente raide en polarisation inverse.

La présente invention vise également à proposer un procédé de formation d'une telle diode.

Pour atteindre ces objets, la présente invention prévoit une diode de puissance verticale, de redressement et de protection, formée dans une couche semiconductrice faiblement dopée d'un premier type de conductivité, reposant sur un substrat fortement dopé du premier type de conductivité, comprenant une première région annulaire, du premier type de conductivité plus fortement dopée que ladite couche et plus faiblement que ledit substrat, entourant une zone de ladite couche et s'étendant jusqu'au substrat ; et une deuxième région annulaire, dopée du second type de conductivité, s'étendant à la surface de la première région et de part et d'autre de celle-ci ; une première électrode comportant une couche mince d'un matériau propre à former une jonction Schottky avec ladite couche, reposant sur ladite zone de ladite couche et sur au moins une portion de la deuxième région annulaire avec laquelle elle forme un contact ohmique.

Selon un mode de réalisation de la présente invention, le premier type de conductivité est le type N et le second type est le type P.

La présente invention prévoit aussi un procédé de formation d'une diode verticale sur un substrat de silicium monocristallin fortement dopé d'un premier type de conductivité, comportant les étapes consistant à former sur le substrat une couche semiconductrice plus faiblement dopée du premier type de conductivité que le substrat ; former, dans ladite couche, une première région annulaire s'étendant jusqu'au substrat, la première région annulaire étant dopée du premier type de conductivité plus fortement que ladite couche et plus faiblement que ledit substrat ; former une deuxième région annulaire, dopée du second type de conductivité, s'étendant à la surface de la première région et de part et d'autre de celle-ci à la surface de la couche et de la zone ; et déposer, sur ladite zone de ladite couche et sur une portion de la deuxième région annulaire, une couche mince d'un matériau propre à former une jonction Schottky avec ladite couche.

Selon un mode de réalisation de la présente invention, le procédé comporte en outre les étapes consistant à former, en face arrière, une métallisation sur au moins une portion du substrat et, en face avant, une autre métallisation sur au moins une portion de la couche mince.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1A illustre, en vue en coupe partielle et schématique, une diode Schottky ;
la figure 1B illustre schématiquement la caractéristique I(V) d'une diode Schottky ;
la figure 2A illustre, en vue en coupe partielle et schématique, une diode à jonction PN ;
la figure 2B illustre schématiquement la caractéristique I(V) d'une diode PN ;
les figures 3A à 3D illustrent, en vue en coupe partielle et schématique, des étapes de formation d'une diode selon un mode de réalisation de la présente invention ; et
la figure 4 illustre schématiquement la caractéristique I(V) d'une diode selon la présente invention.

Par souci de clarté, les différentes figures ne sont pas tracées à l'échelle. De plus, dans les diverses figures, de mêmes éléments sont désignés par de mêmes références.

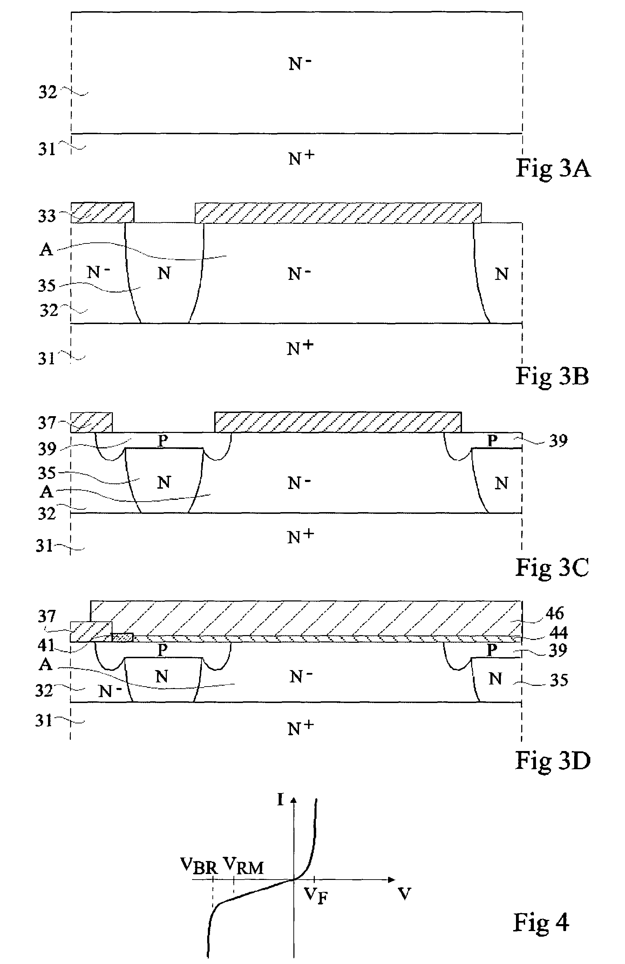

Les figures 3A à 3D illustrent, en vue en coupe partielle et schématique, des étapes d'un procédé de formation d'une diode de puissance verticale selon un mode de réalisation de la présente invention.

Comme l'illustre la figure 3A, le procédé selon l'invention commence par la croissance épitaxiale, sur un substrat 31 de silicium monocristallin d'une couche semiconductrice 32. Le substrat 31 est fortement dopé de type N, alors que la couche 32 est faiblement dopée de type N.

Aux étapes suivantes, illustrées en figure 3B, on dépose un masque 33 à ouverture annulaire à travers lequel on effectue une implantation d'un dopant de type N tel que du phosphore. On délimite ainsi dans la couche 32 une zone A entourée d'une région annulaire 35. Les conditions d'implantation et du recuit de diffusion sont choisies de façon que la région annulaire 35 traverse toute la couche 32 et atteint le substrat 31. La région annulaire 35 est dopée de type N plus fortement que la zone A (couche 32) mais plus faiblement que le substrat 31.

Aux étapes suivantes, illustrées en figure 3C, le masque 33 est retiré et remplacé par un masque 37 présentant une ouverture annulaire de dimensions supérieures à celles du masque 33, autour de la première région annulaire 35. On forme ensuite par implantation/diffusion une deuxième région annulaire 39 de type P. La deuxième région 39 recouvre la surface supérieure de la région annulaire 35 et s'étend de part et d'autre de celle-ci, vers l'intérieur et vers l'extérieur. On notera que la portion de la deuxième région 39 s'étendant à l'extérieur de la première région 35 résulte d'une diffusion plus profonde que la partie centrale, ce qui renforce le fait que la jonction PN active est la jonction à l'interface entre les couches 35 et 39.

Ensuite, comme l'illustre la figure 3D, on retire la partie du masque 37 protégeant la surface supérieure de la zone A et on forme un masque supplémentaire 41 destiné à étendre vers l'intérieur le masque 37 au-dessus d'une partie externe de la région annulaire 35. Ensuite, on forme dans l'espace dégagé par le masque 37-41 une couche mince 44 propre à former une jonction Schottky avec la zone A. La couche 44 recouvre les parties centrale et interne de la région annulaire 39 avec laquelle elle forme un contact ohmique. Ensuite, on forme sur la couche 44 une métallisation 46 destinée à constituer l'anode de la diode de redressement et de protection selon l'invention.

Le procédé selon l'invention se poursuit par des étapes usuelles de formation d'un composant, notamment la formation en face arrière du substrat 31 d'une métallisation destinée à former une autre électrode, ici la cathode, de la diode selon l'invention.

On obtient donc une diode constituée d'une jonction Schottky centrale 44-A en parallèle avec une jonction PN périphérique 39-35. La structure selon l'invention permet avantageusement de concilier les contraintes de dopage divergentes des diodes Schottky et PN.

La figure 4 illustre la caractéristique I(V) d'une diode selon la présente invention, par exemple d'une structure similaire à celle de la figure 3D. En polarisation directe, la diode selon la présente invention se comporte comme une diode Schottky 38-A et présente une chute de tension relativement faible qui dépend du niveau de dopage de la zone A et du métal Schottky utilisé. En polarisation inverse, la diode se comporte comme une jonction PN 39-35 et présente un comportement en avalanche raide qui dépend essentiellement du dopage de la première région annulaire 35. Les dopages de la zone A (couche 32) et de la première région annulaire 35 peuvent avantageusement être optimisés indépendamment pour minimiser la chute de tension en direct et maximiser la tenue en tension en inverse tout en réduisant les courants en inverse (la consommation de puissance en inverse), respectivement.

A titre d'exemple non limitatif, les différents éléments de la figure 3D présenteront les caractéristiques suivantes :
- substrat 31 : silicium monocristallin, dopé de type N avec une concentration de l'ordre de 10¹⁹ à 10²⁰ at./cm³ ;
- couche 32 : épaisseur initiale de l'ordre de 10 à 20 µm pour obtenir après recuit une épaisseur de l'ordre de 5 à 6 µm ; dopage de type N avec une concentration de l'ordre de 10¹⁵ à 10¹⁶ at./cm³ ;
- région annulaire 35 : dopage de type N de 10¹⁷ à 10¹⁸ at./cm³, choisi en fonction de la tension de claquage souhaitée en polarisation inverse ;
- région annulaire 39 : dopage de type P de l'ordre de 10¹⁹ at./cm³.

Dans de telles conditions, on obtient une diode de puissance qui a une tension inverse à 1 mA de l'ordre de 16 V et une tension inverse à un ampère de l'ordre de 20 V, et une chute de tension en direct à un ampère de l'ordre de 400 mV.

Il sera clair que les caractéristiques inverse de la diode PN sont choisies pour que, en inverse, ce soit cette diode PN qui détermine les caractéristiques de la diode selon la présente invention.

Bien entendu, la présente invention est susceptible de diverses variantes et modifications qui apparaîtront à l'homme de l'art. En particulier, l'homme de l'art saura ajuster les niveaux de dopage et les profondeurs des différentes régions aux performances recherchées. Par ailleurs, on a considéré précédemment que la diode est formée dans une couche 32 reposant sur un substrat 31. Toutefois, l'homme de l'art comprendra que de telles zones de dopage différentes peuvent être obtenues par des procédés d'épitaxie ou de dopages spécifiques par diffusion/implantation dans un substrat massif. Ainsi, la couche 32 pourrait résulter d'un dopage uniforme d'une tranche semiconductrice et le substrat 31 pourrait résulter d'une épitaxie et/ou d'une implantation spécifique de la face arrière de la tranche.

## Revendications

1. Diode de puissance verticale, de redressement et de protection, formée dans une couche semiconductrice (32) faiblement dopée d'un premier type de conductivité, reposant sur un substrat (31) fortement dopé du premier type de conductivité, comprenant :
une première région annulaire (35), du premier type de conductivité plus fortement dopée que ladite couche et plus faiblement que ledit substrat, entourant une zone (A) de ladite couche et s'étendant jusqu'au substrat ;
une deuxième région annulaire (39), dopée du second type de conductivité (P), s'étendant à la surface de la première région et de part et d'autre de celle-ci ;
une première électrode comportant une couche mince (44) d'un matériau propre à former une jonction Schottky avec ladite couche, reposant sur ladite zone de ladite couche et sur au moins une portion de la deuxième région annulaire avec laquelle elle forme un contact ohmique.

2. Diode selon la revendication 1, dans laquelle le premier type de conductivité est le type N et le second type est le type P.

3. Procédé de formation d'une diode verticale sur un substrat de silicium monocristallin (31) fortement dopé d'un premier type de conductivité (N+), **caractérisé en ce qu'**il comporte les étapes suivantes :
former sur le substrat une couche semiconductrice (32) plus faiblement dopée du premier type de conductivité (N-) que le substrat ;
former, dans ladite couche, une première région annulaire (35) s'étendant jusqu'au substrat, la première région annulaire étant dopée du premier type de conductivité (N) plus fortement que ladite couche et plus faiblement que ledit substrat ;
former une deuxième région annulaire (39), dopée du second type de conductivité (P), s'étendant à la surface de la première région et de part et d'autre de celle-ci à la surface de la couche et de la zone ; et
déposer, sur ladite zone de ladite couche et sur une portion de la deuxième région annulaire, une couche mince (44) d'un matériau propre à former une jonction Schottky avec ladite couche.

4. Procédé selon la revendication 3, comportant en outre les étapes consistant à former, en face arrière, une métallisation sur au moins une portion du substrat (31) et, en face avant, une autre métallisation (46) sur au moins une portion de la couche mince (44).

## Claims

1. A vertical rectifying and protection power diode, formed in a lightly-doped semiconductor layer (32) of a first conductivity type, resting on a heavily-doped substrate (31) of the first conductivity type, comprising:
a first ring-shaped region (35) of the first conductivity type, more heavily doped than said layer and more lightly doped than said substrate, surrounding an area (A) of said layer and extending to the substrate;
a second ring-shaped region (39), doped of the second conductivity type (P), extending at the surface of the first region and on either side thereof;
a first electrode comprising a thin layer of a material (44) capable of forming a Schottky diode with said layer, resting on said area of said layer and on at least a portion of the second ring-shaped region with which it forms an ohmic contact.

2. The diode of claim 1, wherein the first conductivity type is type N and the second type is type P.

3. A method for forming a vertical diode on a heavily-doped single-crystal silicon substrate (31) of a first conductivity type (N⁺), comprising the steps of:
forming on the substrate a semiconductor layer (32) of the first conductivity type (N⁻) more lightly doped than the substrate;
forming, in said layer, a first ring-shaped region (35) extending to the substrate, the first ring-shaped region being doped of the first conductivity type (N) more heavily than said layer and more lightly than said substrate;
forming a second ring-shaped region (39), doped of the second conductivity type (P), extending at the surface of the first region and on either side thereof at the surface of the layer and of the area; and
depositing, on said area of said layer and on a portion of the second ring-shaped region, a thin layer (44) of a material capable of forming a Schottky junction with said layer.

4. The method of claim 3, further comprising the steps of forming, at the rear surface, a metallization on at least a portion of the substrate (31) and, at the front surface, another metallization (46) on at least a portion of the thin layer (44).

## Patentansprüche

1. Vertikale Gleichrichtungs- und Schutzleistungsdiode, die in einer schwach dotierten Halbleiterschicht (32) eines ersten Leitfähigkeitstyps ausgeformt ist, die auf einem stark dotierten Substrat (31) des ersten Leitfähigkeitstyps liegt, die Folgendes aufweist:
eine erste ringförmige Region (35) des ersten Leitfähigkeitstyps, die stärker dotiert ist als die Schicht und schwächer dotiert ist als das Substrat, die einen Bereich (A) der Schicht umgibt und sich zum Substrat erstreckt;
eine zweite ringförmige Region (39), die mit dem zweiten Leitfähigkeitstyp (P) dotiert ist, die sich an der Oberfläche der ersten Region und auf jeder Seite davon erstreckt;
eine erste Elektrode, die eine dünne Schicht aus einem Material (44) aufweist, welches fähig ist, eine Schottky-Diode mit der Schicht zu bilden, die auf dem Bereich der Schicht und zumindest einem Teil der zweiten ringförmigen Region ruht, mit der sie einen Ohmschen Kontakt bildet.

2. Diode nach Anspruch 1, wobei der erste Leitfähigkeitstyp N ist, und wobei der zweite Leitfähigkeitstyp P ist.

3. Verfahren zum Formen einer vertikalen Diode auf einem stark dotierten einkristallinen Siliziumsubstrat (31) eines ersten Leitfähigkeitstyps (N⁺), welches folgende Schritte aufweist:
Formen einer Halbleiterschicht (32) auf dem Substrat, und zwar mit dem ersten Leitfähigkeitstyp (N⁻), die schwächer dotiert ist als das Substrat;
Formen einer ringförmigen Region (35) in der Schicht, welche sich zum Substrat hin erstreckt, wobei die erste ringförmige Region mit dem ersten Leitfähigkeitstyp (N) stärker dotiert ist als die Schicht und schwächer dotiert ist als das Substrat;
Formen einer zweiten ringförmigen Region (39), die mit dem zweiten Leitfähigkeitstyp (P) dotiert ist, die sich an der Oberfläche der ersten Region und an jeder Seite davon an der Oberfläche der Schicht und des Bereiches erstreckt; und
Ablagern einer dünnen Schicht (44) aus einem Material, welches einen Schottky-Übergang mit der Schicht bilden kann auf dem Bereich der Schicht und auf einem Teil der zweiten ringförmigen Region.

4. Verfahren nach Anspruch 3, welches weiter die Schritte aufweist, an der Hinterseite eine Metallisierung auf zumindest einem Teil des Substrates (31) zu bilden, und auf der Vorderseite eine andere Metallisierung (46) auf zumindest einem Teil der dünnen Schicht (44) zu bilden.
